# EUROPEAN PATENT SPECIFICATION

(11) **EP 3 955 715 B1**
(45) Date of publication and mention of the grant of the patent: **07.08.2024**
(21) Application number: 21190520.3
(22) Date of filing: 10.08.2021
(51) Int. Cl.: H05K 7/14, G06F 1/18, G06F 1/26

(54) **SERVER**
SERVER
SERVEUR

(30) Priority: 10.08.2020 CN 202021648734 U
(43) Date of publication of application: 16.02.2022
(73) Proprietor: CMOTION TECHNOLOGIES LIMITED, HONG KONG (CN)
(72) Inventor: YANG, Bin, Beijing, 100083 (CN)
(74) Representative: Petraz, Gilberto Luigi

(56) References cited:
- EP-A2- 1 466 511
- CA-A1- 3 104 067
- US-A1- 2002 008 961
- US-A1- 2005 071 689
- US-A1- 2013 111 098
- US-A1- 2014 308 828
- US-A1- 2015 138 725
- US-A1- 2020 077 544
- US-B1- 9 377 832

## Description

### FIELD OF THE INVENTION

The disclosure relates to the field of servers, and particularly to a server.

### BACKGROUND

In the related art, server includes a power module, a plurality of Hash boards and control modules, and the power module supplies power to the plurality of Hash boards and control modules at the same time. In this way, on the one hand, the stability of power supply is low; on the other hand, when the power supply fails, it is unable to quickly check the fault location. In addition, the disassembly of the plurality of modules of the server is complex and inefficient.

EP1466511 discloses a modular computer system comprising at least one information processing module removably received at a first face of a housing, at least one computer support module removably received at a second face of the housing, and at least one power supply module removably received at the second face of the housing, a connections member is provided. A midplane is provided between the information processing module on a first side, and the computer support module and the power supply module on the other side, to electrically connect the same.

US 2015/0138725 discloses an electrical equipment chassis which includes a frame open to a first side and an opposite second side and a power board located near a midplane of the chassis coupling power supply modules to a first networking module and a second networking module. The chassis contains a first region, a second region and a third region, this latter being at least partially separated from the first region by the power board, and only partially separated from the second region by the same power board.

### SUMMARY

To solve the problems in the related art, one objective of the disclosure is to provide a server with good stability, high troubleshooting and maintenance efficiency.

According to the invention, the server comprises: a housing in the shape of a frame structure and comprising a first accommodation cavity, a second accommodation cavity, a third accommodation cavity, and a fourth accommodation cavity; a plurality of Hash boards, the plurality of Hash boards being disposed side by side in the first accommodation cavity along a left-right direction; each of the plurality of Hash boards being perpendicular to the left-right direction, and each Hash board being slidably disposed in the first accommodation cavity; a power module disposed in the second accommodation cavity; a control module slidably disposed in the third accommodation cavity; a power supply module slidably disposed in the fourth accommodation cavity; the fourth accommodation cavity and the third accommodation cavity being distributed in the left-right direction and spaced apart from each other; an electrical connection board disposed in the housing, wherein the plurality of Hash boards, the power module, the control module, and the power supply module are all connected to the electrical connection board; the power module is configured to supply power to the plurality of Hash boards via the electrical connection board, and the power supply module is configured to supply power to the control module via the electrical connection board.

With respect to the server of the disclosure, the power module is configured to supply power to the plurality of Hash boards via the electrical connection board; the power supply module is configured to supply power to the control module via the electrical connection board, thus achieving the dual circuit power supply of the server. The two circuits do not interfere with each other, which improves the stability of the circuits. In addition, the two circuits can be provided with different voltages, and can also provide different voltages to the Hash boards and the control module, which improves the adaptability and further improves the security and stability of power supply. When one of the circuits fails, the other circuit will not be affected, so that when one part of a circuit is abnormal, another part of the circuit will not be damaged, thus improving the efficiency of troubleshooting and maintenance. In this way, the sever is modularized, which is convenient for the maintenance and installation/uninstallation of each module independently.

In accordance with the invention, the power module is slidably disposed in the second accommodation cavity of the housing, and an extension direction of the power module is the same as that of the plurality of Hash boards; and the plurality of Hash boards, the control module and the power supply module are all disposed on one side of the electrical connection board along a front and rear direction; and the front and rear direction is parallel to the extension direction of the plurality of Hash boards.

Moreover, a plurality of power modules are disposed in the left-right direction, and each power module is configured to supply power for 2 to 4 Hash boards.

The electrical connection board comprises: a PCB substrate, the PCB substrate comprising two contact areas configured to connect to positive and negative electrodes of a power supply, respectively, and two sides of each contact area being respectively provided with a first contact surface and a second contact surface configured to contact a conductor, and each contact area comprising a plurality of through holes; a first conductive layer disposed on the first contact surface and a second conductive layer disposed on the second contact surface; a third conductive layer disposed in the through holes and electrically connected to the first conductive layer and the second conductive layer; a first conductive strip, the first conductive strip being fixed on the first conductive layer and electrically connected to the first conductive layer, and the first conductive strip being configured to connect to the power module; and a second conductive strip, the second conductive strip being connected to the second conductive layer and electrically connected to the second conductive layer, and the second conductive strip being electrically connected to the Hash board of the server. The first conductive strip comprises a first conductive sheet, a second conductive sheet and a connection sheet, the first conductive sheet being connected to the first conductive layer, and the second conductive sheet being connected to the power supply module, wherein the connection sheet is disposed between the first conductive sheet and the second conductive sheet.

In certain embodiments, each Hash board comprises a buck circuit module; the power supply module is configured to convert a first AC voltage of an external first AC into DC and supply the DC to the buck circuit module; and the buck circuit module is configured to reduce the DC and supplies power to a Hash chip on the Hash board.

In certain embodiments, a first DC voltage of the DC converted by the power module is 48 V, and a second DC voltage of the DC reduced by the buck circuit module of the Hash board is 12 V.

In certain embodiments, the power supply module is configured to convert a second AC voltage of an external second AC into a third DC voltage of 12 V and supply power to the control module.

In certain embodiments, a range of the first AC voltage and the second AC voltage is 220-380 V.

In certain embodiments, the control module comprises a control board and a first circuit board disposed on one end of the control board; the first circuit board comprises a first control signal interface and a second control signal interface; the first control signal interface is connected to a first port of the electrical connection board for signal connection; and the second control signal interface is connected to a second port of the electrical connection board for current transport; and two sides of the third accommodation cavity are provided with sliding bars, and two sides of the control board are provided with sliding grooves; the control board is movable in the third accommodation cavity when the sliding bars are sliding in the sliding grooves.

In certain embodiments, the power supply module comprises a power supply board and a second circuit board disposed on one end of the power supply board; the second circuit board comprises a first current interface and a second current interface; the first current interface is configured to connect to a third port of the electrical connection board to access an external voltage, and the second current interface is configured to connect to a fourth port of the electrical connection board to transmit the current.

In certain embodiments, the electrical connection plate further comprises two conductive connection plates and an insulating layer; the two conductive connection plates are respectively connected to second conductive strips of the two contact areas to connect to the positive electrode and the negative electrode of the power supply respectively; each conductive connection plate is provided with a plurality of conductive pins, and the conductive pins on the two conductive connection plates match each other one by one to form a plurality of pairs of conductive pins; each pair of conductive pins corresponds to each Hash board and is electrically connected to the Hash board for power supply; and the insulating layer is disposed between the two conductive connection plates to avoid short circuit between the conductive connection plates connecting the positive electrode and the negative electrode of the power supply.

The additional features and advantages of the disclosure will be given in the following description, which will become obvious from the following description, or can be learned from the implementation of the disclosure.

### BRIEF DESCRIPTION OF THE DRAWINGS

The above and/or additional aspects and advantages of the disclosure will become obvious and easy to understand from the description of the embodiment in combination with the following drawings:
FIG. 1 is an angle of view of a server according to one embodiment of the disclosure;
FIG. 2 is another angle of view of a server according to one embodiment of the disclosure;
FIG. 3 is an angle of view of a circuit board according to one embodiment of the disclosure;
FIG. 4 is another angle of view of a circuit board according to one embodiment of the disclosure;
FIG. 5 is still another angle of view of a circuit board according to one embodiment of the disclosure;
FIG. 6 is a sectional view taken from line A-A in FIG. 5;
FIG. 7 is an enlarged view of part B in FIG. 6;
FIG. 8 is an enlarged view of part C in FIG. 7;
FIG. 9 is a schematic view of a control module according to one embodiment of the disclosure; and
FIG. 10 is a schematic view of a power supply module according to one embodiment of the disclosure.

### Numerals in the figures:

1000. Server; 230. Housing; 231. First accommodation cavity; 232. Second accommodation cavity; 233. Third accommodation cavity; 234. Fourth accommodation cavity;
210. Hash board; 220. Power module; 240. Control module; 241. Control board; 242. Sliding groove; 243. First control signal interface; 244. Locating base; 245. Second control signal interface; 246. First circuit board; 250. Power supply module; 251. Power supply board; 252. First current interface; 253. Second current interface; 254. Second circuit board; 260. Fifth port; 270. Fastening screw;
100. Electrical connection board; 10. PCB substrate; 11. Contact area; 112. Second contact surface; 13. Through hole; 114. Screw hole; 115. Guide post; 116. First port; 117. Second port; 118. Third port; 119. Fourth port; 20. First conducting layer; 30. Second conducting layer; 40. Third conducting layer; 50. First conductive strip; 51. First conducting sheet; 52. Second conducting sheet; 521. Hole; 53. Connection sheet; 60. Second conductive strip; 70. Conductive connecting plate; 71. Conductive pin; 80. Insulating layer.

### DETAILED DESCRIPTION

The embodiments of the disclosure are described in detail below with reference to the attached exemplary drawings.

In the description of the disclosure, it should be understood that the orientation or position relationship indicated by the terms "thickness" , "horizontal" , "up" , "down" , "bottom" , "front" , "back" , "left" , "right" , "inside" and "outside" is based on the orientation or position relationship shown in the figure, only for the convenience of describing the disclosure and simplifying the description, not to indicate or imply that the device or element must have a specific orientation, be constructed and operated in a specific orientation, and it cannot be understood as a limitation to the disclosure.

In the description of the disclosure, "plurality" means two or more.

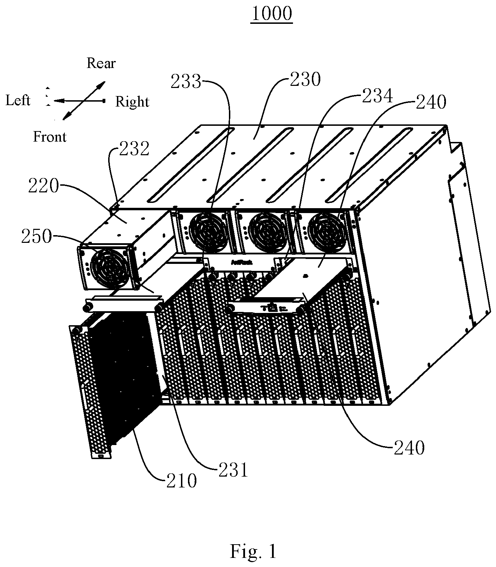

As shown in FIGS. 1-10, a server 1000 of the disclosure comprises a housing 230, a plurality of Hash boards 210, a power module 220, a control module 240, a power supply module 250, and an electrical connection board 100.

As shown in FIGS. 1-2, the housing 230 is in the shape of a frame structure. The plurality of Hash boards are disposed side by side in the first accommodation cavity 231 of the housing 230 along the left-right direction. Each of the plurality of Hash boards 230 is perpendicular to the left-right direction, and each Hash board 230 is slidably disposed in the first accommodation cavity 231. Through pushing or pulling the Hash board 210, the Hash board 210 can be installed in or detached from the housing, thus facilitating the installation and uninstallation of the Hash board 210. The power module 220 is disposed in the second accommodation cavity 232 of the housing 230. The control module 240 is slidably disposed in the third accommodation cavity 233 of the housing 230. The power supply module 250 is slidably disposed in the fourth accommodation cavity 234 of the housing 230. Through pushing or pulling the control module 240 and the power supply module 250, the control module 240 and the power supply module 250 can be installed in or detached from the housing, thus facilitating the installation and uninstallation thereof. The fourth accommodation cavity 234 and the third accommodation cavity 233 are distributed in the left-right direction and spaced apart from each other. The electrical connection board 100 is disposed in the housing 230. In this way, the sever 1000 is modularized, which is convenient for the maintenance and installation/uninstallation of each module independently.

The plurality of Hash boards 210, the power module 220, the control module 240, and the power supply module 250 are all connected to the electrical connection board 100; the power module 220 supplies power to the plurality of Hash boards 210 via the electrical connection board 100, and the power supply module 250 supplies power to the control module 240 via the electrical connection board 100, thus achieving the dual circuit power supply of the server 1000.

With respect to the server 1000 of the disclosure, the power module 220 supplies power to the plurality of Hash boards 210 via the electrical connection board 100, the power supply module 250 supplies power to the control module 240 via the electrical connection board 100, thus achieving the dual circuit power supply of the server 1000. The two circuits do not interfere with each other, which improves the stability of the circuits. In addition, the two circuits can be provided with different voltages, and can also provide different voltages to the Hash boards 210 and the control module 240, which improves the adaptability and further improves the security and stability of power supply. When one of the circuits fails, the other circuit will not be affected, so that when one part of a circuit is abnormal, another part of the circuit will not be damaged, thus improving the efficiency of troubleshooting and maintenance. In this way, the sever 1000 is modularized, which is convenient for the maintenance and installation/uninstallation of each module independently.

The power module 220 is slidably disposed in the second accommodation cavity 232 of the housing 230, and the extension direction of the power module 220 is the same as that of the plurality of Hash boards 210. The plurality of Hash boards 210, the control module 240 and the power supply module 250 are all disposed on one side of the electrical connection board 100 along the front and rear direction. The front and rear direction is parallel to the extension direction of the plurality of Hash boards 210. In this way, the electrical connection board 100 and the plurality of Hash boards 210, the electrical connection board 100 and the control module 240, and the electrical connection board 100 and the power supply module 250 are connected easily.

A plurality of power modules 220 are disposed in the left-right direction, and each power module 220 is configured to supply power for two to four Hash boards 210. For example, the server 1000 comprises twelve Hash boards 210 and four power modules 220, and each power module supplies power for three Hash boards 210, thus improving the efficiency of the server 1000.

In accordance with one embodiment of the disclosure, each Hash board 210 comprises a buck circuit module. The power supply module 220 is configured to convert the first AC voltage of an external first AC into DC and supply the DC to the buck circuit module. The buck circuit module reduces the DC voltage and supplies power to the Hash chip on the Hash board 210. Through the arrangement of the buck circuit module, the high voltage can be converted into low voltage, and the power supply can be provided to the Hash chip on the Hash board 210, which is convenient to realize the dual circuit power supply of the server 1000. For example, the buck circuit module may be disposed on the Hash board 210.

In certain embodiments, the first DC voltage of the DC power converted by the power module 220 is 48 V, and the second DC voltage of the DC power reduced by the buck circuit module of the Hash board 210 is 12 V, which is then input to the Hash chip on the Hash board 210 for power supply. In certain embodiments, the power supply module 250 converts the second AC voltage of the external second AC into the third DC voltage of 12 V and then supplies power to the control module 240, thus achieving the dual circuit power supply of the server 1000 and improving the stability of the circuit.

In certain embodiments, the range of the first AC voltage and the second AC voltage is 220-380 V. The two circuits can be provided with different voltages, and the Hash board 210 and the control module 240 can also be provided with different voltages, thus improving the power supply safety and stability. For example, the first AC voltage can be 380 V or 220 V, and the second AC voltage can be 220 V.

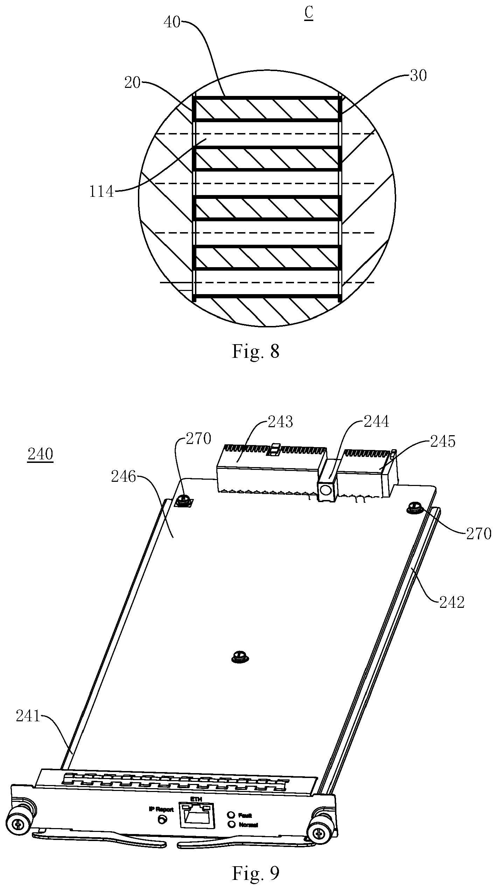

As shown in FIGS. 1 and 9, the control module 240 comprises a control board 241 and a first circuit board 246 disposed on one end of the control board 241 (for example, the rear end in FIG. 1). The first circuit board 246 comprises a first control signal interface 243 and a second control signal interface 245. The first control signal interface 243 is connected to the first port 116 of the electrical connection board 100 for signal connection. The second control signal interface 245 is connected to the second port 117 of the electrical connection board 100 for current transport. The electrical connection board 100 can be disposed at the rear end of the control module 240 to facilitate the connection of the first control signal interface 243 to the electrical connection board 100 thereby achieving the signal connection. The control board 241 can carry the first circuit board 246 to ensure the stable connection between the first circuit board 246 and the electrical connection board 100.

Two sides of the third accommodation cavity 233 is provided with sliding bars, and two sides of the control board 241 are provided with sliding grooves 242. The control board 241 can move in the third accommodation cavity 233 when the sliding bars are sliding in the sliding grooves 242. The arrangement of the sliding bars and the sliding grooves 242 can facilitate the uninstallation of the control module 240, and the signal connection between the control module 240 and the electrical connection board 100 can be turned on or off by sliding the control board 241. As shown in FIG. 9, the control module 240 and the power supply module 250 each comprise a locating base 244, and the electrical connection board 100 is provided with a guide post which can extend into the positioning hole of the locating base 244, so as to facilitate the installation and positioning of the control module 240 and the electrical connection board 100, and the power supply module 250 and the electrical connection board 100, thus improving the installation efficiency of the control module 240 and the electrical connection board 100, and the power supply module 250 and the electrical connection board 100.

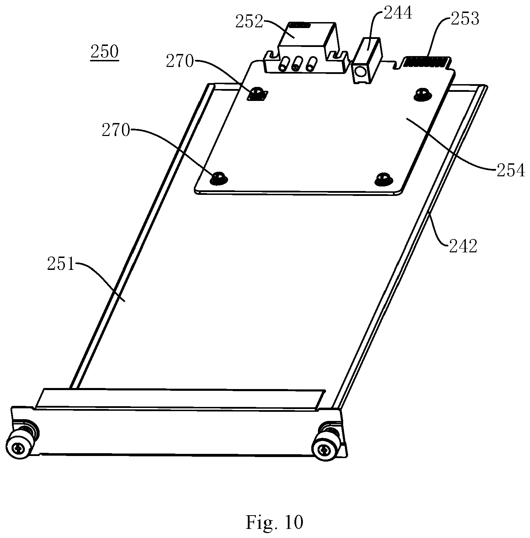

As shown in FIG. 10, the power supply module 250 comprises a power supply board 251 and a second circuit board 254 disposed on one end of the power supply board 251. The second circuit board 254 comprises a first current interface 252 and a second current interface 253. The first current interface 252 is configured to connect to the third port 118 of the electrical connection board 100 to access the external voltage, and the second current interface 253 is configured to connect to the fourth port 119 of the electrical connection board 100 to transmit the current. In this way, the power supply module 250 can access the external voltage and transmit the voltage to the electrical connection board 100 electrically connected to the control module 240, so that the power supply module 250 supplies power to the control module 240.

In certain embodiments, the power supply module 250 comprises a protective cover (not shown in the figure). The protective cover is disposed on the second circuit board 254 to protect the second circuit board 254. Optionally, the protective cover can be provided with an opening facing the electrical connection board 100, so as to facilitate the connection of the first current interface 252, the second current interface 253 and the locating base 244 with the electrical connection board 100.

As shown in FIGS. 1 and 10, two sides of the four accommodation cavity 234 is provided with sliding bars, and two sides of the power supply board 251 are provided with sliding grooves 242. The power supply board 251 can move in the four accommodation cavity 234 when the sliding bars are sliding in the sliding grooves 242, thus facilitating the uninstallation of the power supply module 250, and the signal connection between the power supply module 250 and the electrical connection board 100 can be turned on or off by sliding the power supply board 251.

For example, an external 380 V or 220 V AC voltage is introduced and converted by the power module 220 into 48 V DC voltage. The Hash board 210 can be equipped with a buck circuit module to reduce the DC voltage to 12 V, and then input to the Hash chip on the Hash board 210 for power supply. In addition, the power supply module 250 can receive a 220 V AC voltage from outside or from the electrical connection board 100, and convert the 220 V AC voltage into a 12 V DC voltage, and then supply the power for the control module 240. In this way, the control module 240 and the Hash board 210 are separately powered, realizing the dual circuit power supply of the server 1000.

Optionally, the server 1000 is provided with a fifth port 260 for receiving an external voltage (for example, 220 V AC voltage), and the second port 117 is connected to the first current interface 252, so that the voltage can be connected to the power supply module 250 through the electrical connection board 100. The first circuit board 246 can be a buck circuit board, thereby reducing the voltage (for example, convert 220 V AC voltage into 12 DC voltage). The second current interface 253 of the power supply module 250 (for example, the second current interface 253 can be a gold finger interface) can be plugged into the fourth port 119 of the electrical connection board 100 to transmit the voltage to the electrical connection board 100 to supply power to the control module 240.

Specifically, the electrical connection board 100 can transmit current to the first port 116, and the control module 240 comprises the first control signal interface 243 and the second control signal interface 245. For example, the first control signal interface 243 can be connected to the first port 116 to receive the current, so that the power supply module 250 can supply power to the control module 240. The second control signal interface 245 may be connected to the second port 117 of the electrical connection board 100 to transmit information, for example, transmitting control information and receiving feedback information. Optionally, the electrical connection board 100 can also transmit the current to the second port 117, the second control signal interface 245 can be connected to the second port 117 to receive the current, and the first control signal interface 243 can be connected to the first port 116 to transmit information, which is not limited here.

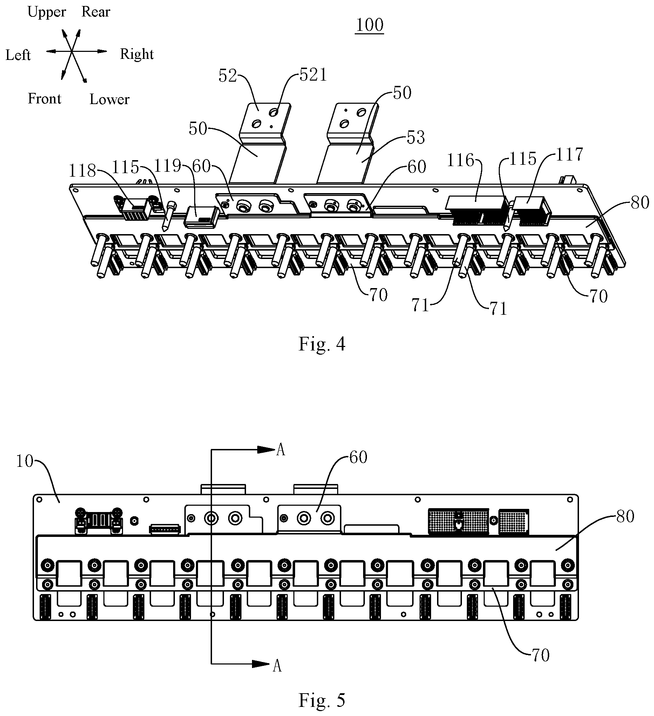

For example, as shown in FIGS. 9 and 10, the first circuit board 246 and the second circuit board 254 can respectively protrude out of the rear ends, as shown in FIG. 4, of the control board 241 and the power supply board 251, so that a plurality of interfaces can be connected to a plurality of ports, and the connection is stable. The first circuit board 246 can be fixedly disposed on the control board 241 through a plurality of fastening screws 270, and the second circuit board 254 can be fixedly disposed on the power supply board 251 through a plurality of fastening screws 270, thereby improving the connection stability.

For example, the control board 241, the power supply board 251, and the protective cover are all made of metal materials thus ensuring the good structural strength of the control module 240 and the power supply module 250. At the same time, the control board 241 and the power supply board 251 are both provided with the sliding grooves 242, which can facilitate the sliding cooperation between the sliding grooves 242 and the sliding bars, ensure the smooth sliding of the sliding grooves 242 and the sliding bars, and facilitate the detachable connection between the power supply board 251/the control board 241 and the housing 230, thus improving the reliability of the electrical connection or disconnection between the power supply module 250 and the electrical connection board 100, and between the control module 240 and the electrical connection board 100.

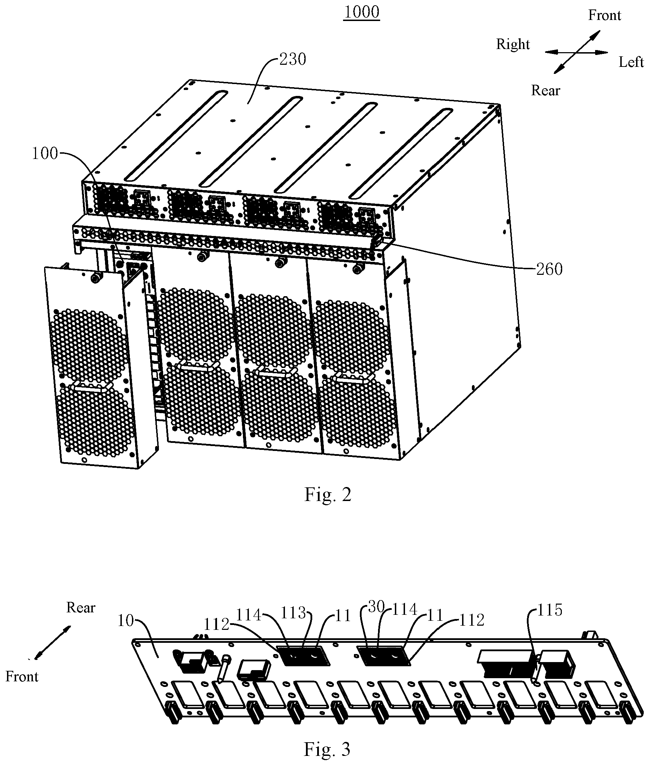

As shown in FIGS. 3-8, the electrical connection board 100 comprises a PCB substrate 10, a first conductive layer 20, a second conductive layer 30, a third conductive layer 40, a first conductive strip 50 and a second conductive strip 60. The PCB substrate 10 comprises two contact areas 11 configured to connect to the positive and negative electrodes of a power supply, respectively, and two sides of each contact area 11 are respectively provided with a first contact surface (not shown in the figure) and a second contact surface 112 configured to contact a conductor. "Two sides of the contact area 11" refer to two sides in the front and rear direction, for example, as shown in FIG. 3 and FIG. 4. Each contact area 11 comprises a plurality of through holes 113. As shown in FIG. 3, FIG. 7 and FIG. 8, the first contact surface and the second contact surface 112 are disposed oppositely to each other along the front and rear direction as shown in FIG. 3, and the through hole 113 runs through the first contact surface and the second contact surface 112 along the front and rear direction as shown in FIG. 3.

The first conductive layer 20 is disposed on the first contact surface, the second conductive layer 30 is disposed on the second contact surface 112, and the third conductive layer 40 is disposed in the through hole 113 and electrically connected to the first conductive layer 20 and the second conductive layer 30. The first conductive strip 50 is fixed on the first conductive layer 20 and electrically connected to the first conductive layer 20, and the first conductive strip 50 is configured to connect to the power module 220. The second conductive strip 60 is connected to the second conductive layer 30 and electrically connected to the second conductive layer 30, and the second conductive strip 60 is electrically connected to the Hash board 210 of the server 1000. The PCB substrate 10 is also provided with a screw hole 114, and the first conductive strip 50, the second conductive strip 60 and the PCB substrate 10 are connected by screws.

Thus, the first conductive layer 20, the second conductive layer 30, and the third conductive layer 40 can be connected as a whole, so that the two sides in the front and rear direction of the PCB substrate 10 can be connected to form a conductor. In this way, there is no need to empty the electrical connection board 100 to pass the conductive strip through the electrical connection board 100 to achieve conductivity, thus ensuring the structural reliability of the electrical connection board 100. At the same time, the structural restriction of the electrical connection board 100 on the first conductive strip 50 and the second conductive strip 60 is avoided, so that the first conductive strip 50 and the second conductive strip 60 can be designed to be larger or smaller as needed, presenting in a variety of forms, so that the electrical connection board 100 is compatible with a variety of servers 1000. In addition, the PCB substrate 10 in such a design mode avoids the coupling between the first conductive strip 50 and the second conductive strip 60, and only the first conductive strip 50 or the second conductive strip 60 can be removed, which is convenient for the installation and uninstallation of the electrical connection board 100, and improves the replacement efficiency and maintenance efficiency.

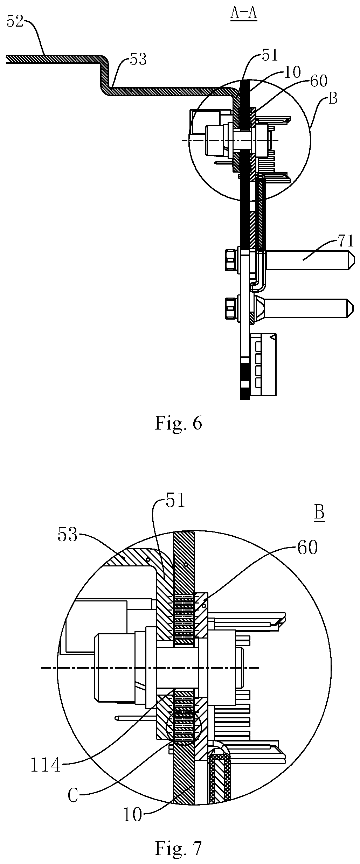

In certain embodiments, as shown in FIGS. 4 and 7, the electrical connection plate 100 further comprises two conductive connection plates 70 and an insulating layer 80. The two conductive connection plates 70 are respectively connected to the second conductive strips 60 of the two contact areas 11 to connect to the positive electrode and the negative electrode of the power supply respectively. Each conductive connection plate 70 is provided with a plurality of conductive pins 71, and the conductive pins 71 on the two conductive connection plates 70 match each other one by one to form a plurality of pairs of conductive pins 71. For example, the two conductive pins 71 disposed in the up and down direction as shown in FIG. 4 form a pair of conductive pins 71. Each pair of conductive pins 71 corresponds to each Hash board 210 and is electrically connected to the Hash board 210 for power supply.

Thus, owing to the arrangement of the conductive pins 71, a plurality of Hash boards 210 can be directly inserted into the electrical connection board 100, without the use of the screws, thus omitting the removal and installation of the screws, simplifying the operation steps, and improving the maintenance efficiency. In addition, the plurality of conductive pins 71 of the electrical connection board 100 can be respectively connected to the plurality of Hash boards 210 to supply power to the plurality of Hash boards 210 at the same time, no need to providing a plurality of electrical connection boards 100, which improves the integration degree of the server 1000 and saves the cost and operation steps.

For example, the conductive connection plate 70 at the upper end as shown in FIG. 4 is connected to the contact area 11 at the left end as shown in FIG. 4, and the contact area 11 can be connected to the negative electrode of the power supply, so that the conductive connection plate 70 is connected to the negative electrode of the power supply. The conductive connection plate 70 at the lower end as shown in FIG. 4 is connected to the contact area 11 at the right end as shown in FIG. 4, and the contact area 11 can be connected to the positive electrode of the power supply, so that the conductive connection plate 70 can be connected to the positive electrode of the power supply, thus achieving the transmission of current.

As shown in FIGS. 4 and 6, the first conductive strip 50 comprises a first conductive sheet 51, a second conductive sheet 52 and a connection sheet 53. The first conductive sheet 51 is connected to the first conductive layer 20, and the second conductive sheet 52 is connected to the power supply module 220. The connection sheet 53 is disposed between the first conductive sheet 51 and the second conductive sheet 52. The first conductive sheet 51, the second conductive sheet 52 and the connection sheet 53 disposed in this way facilitates the connection between the first conductive strip 50 and the power supply module 220. The second conductive sheet 52 comprises a hole 521 through which a fastener passes so that the power module 220 can be firmly connected to the first conductive strip 50.

In certain embodiments, as shown in FIG. 4, the electrical connection board 100 further comprises an insulating layer 80 disposed between the two conductive connection plates 70 to avoid short circuit between the conductive connection plates 70 connecting the positive electrode and the negative electrode of the power supply. The insulating layer 80 is disposed at the positive electrode of the conductive connection plate 70. The insulating layer 80 can be an insulating material coated or plated on the conductive connecting plate 70 of the positive electrode. The insulating layer 80 has good stability and can effectively avoid short circuit between the two conductive connecting plates 70. Optionally, in other embodiments, the insulating layer 80 may be disposed at the negative electrode of the conductive connection plate 70, which is not limited in the disclosure.

## Claims

1. A server (1000), comprising:
a housing (230) in the shape of a frame structure and comprising a first accommodation cavity (231), a second accommodation cavity (232), a third accommodation cavity (233), and a fourth accommodation cavity (234);
a plurality of Hash boards (210), the plurality of Hash boards (210) being disposed side by side in the first accommodation cavity (231) along a left-right direction; each of the plurality of Hash boards (210) being perpendicular to the left-right direction, and each Hash board (210) being slidably disposed in the first accommodation cavity (231);
a power module (220) disposed in the second accommodation cavity (232);
a control module (240) slidably disposed in the third accommodation cavity (233);
a power supply module (250) slidably disposed in the fourth accommodation cavity (234); the fourth accommodation cavity (234) and the third accommodation cavity (233) being distributed in the left-right direction and spaced apart from each other;
an electrical connection board (100) disposed in the housing (230), wherein the plurality of Hash boards (210), the power module (220), the control module (240), and the power supply module (250) are all connected to the electrical connection board (100); the power module (220) is configured to supply power to the plurality of Hash boards (210) via the electrical connection board (100), and the power supply module (250) is configured to supply power to the control module (240) via the electrical connection board (100),
wherein the power module (220) is slidably disposed in the second accommodation cavity (232) of the housing (230), and an extension direction of the power module (220) is the same as that of the plurality of Hash boards (210);
wherein the plurality of Hash boards (210), the control module (240) and the power supply module (250) are all disposed on one side of the electrical connection board (100) along a front and rear direction; and the front and rear direction is parallel to the extension direction of the plurality of Hash boards (210),
wherein a plurality of power modules (220) are disposed in the left-right direction, and each power module (220) is configured to supply power for two to four Hash boards (210),
wherein the electrical connection board (100) comprises: a PCB substrate (10), the PCB substrate (10) comprising two contact areas (11) configured to connect to positive and negative electrodes of a power supply, respectively, and two sides of each contact area (11) being respectively provided with a first contact surface and a second contact surface (112) configured to contact a conductor, and each contact area (11) comprising a plurality of through holes (13);
a first conductive layer (20) disposed on the first contact surface and a second conductive layer (30) disposed on the second contact surface (112);
a third conductive layer (40) disposed in the through holes (13) and electrically connected to the first conductive layer (20) and the second conductive layer (30);
a first conductive strip (50), the first conductive strip (50) being fixed on the first conductive layer (20) and electrically connected to the first conductive layer (20), and the first conductive strip (50) being configured to connect to the power module (220); and
a second conductive strip (60), the second conductive strip (60) being connected to the second conductive layer (30) and electrically connected to the second conductive layer (30), and the second conductive strip (60) being electrically connected to the Hash board (210) of the server (1000),
and wherein the first conductive strip (50) comprises a first conductive sheet (51), a second conductive sheet (52) and a connection sheet (53), the first conductive sheet (51) being connected to the first conductive layer (20), and the second conductive sheet (52) being connected to the power supply module (220), wherein the connection sheet (53) is disposed between the first conductive sheet (51) and the second conductive sheet (52).

2. The server (1000) of claim 1, wherein each Hash board (210) comprises a buck circuit module; the power supply module (250) is configured to convert a first AC voltage of an external first AC into DC and supply the DC to the buck circuit module; and the buck circuit module is configured to reduce the DC and to supply power to a Hash chip on the Hash board (210).

3. The server (1000) of claim 2, wherein a first DC voltage of the DC converted by the power module (220) is 48 V, and a second DC voltage of the DC reduced by the buck circuit module of the Hash board (210) is 12 V.

4. The server (1000) of claim 2, wherein the power supply module (250) is configured to convert a second AC voltage of an external second AC into a third DC voltage of 12 V and supply power to the control module (240).

5. The server (1000) of claim 4, wherein a range of the first AC voltage and the second AC voltage is 220-380 V.

6. The server (1000) of claim 1, wherein the control module (240) comprises a control board (241) and a first circuit board (246) disposed on one end of the control board (241); the first circuit board (246) comprises a first control signal interface (243) and a second control signal interface (245); the first control signal interface (243) is connected to a first port (116) of the electrical connection board (100) for signal connection; and the second control signal interface (245) is connected to a second port (117) of the electrical connection board (100) for current transport; and
two sides of the third accommodation cavity (233) are provided with sliding bars, and two sides of the control board (241) are provided with sliding grooves (242); the control board (241) is movable in the third accommodation cavity (233) when the sliding bars are sliding in the sliding grooves (242).

7. The server (1000) of claim 6, wherein the power supply module (250) comprises a power supply board (251) and a second circuit board (254) disposed on one end of the power supply board (251); the second circuit board (254) comprises a first current interface (252) and a second current interface (253); the first current interface (252) is configured to connect to a third port (118) of the electrical connection board (100) to access an external voltage, and the second current interface (253) is configured to connect to a fourth port (119) of the electrical connection board (100) to transmit the current.

8. The server (1000) of claim 1, wherein the electrical connection plate further comprises two conductive connection plates (70) and an insulating layer (80); the two conductive connection plates (70) are respectively connected to second conductive strips (60) of the two contact areas (11) to connect to the positive electrode and the negative electrode of the power supply respectively; each conductive connection plate (70) is provided with a plurality of conductive pins (71), and the conductive pins (71) on the two conductive connection plates (70) match each other one by one to form a plurality of pairs of conductive pins (71); each pair of conductive pins (71) corresponds to each Hash board (210) and is electrically connected to the Hash board (210) for power supply; and
the insulating layer (80) is disposed between the two conductive connection plates (70) to avoid short circuit between the conductive connection plates (70) connecting the positive electrode and the negative electrode of the power supply.

## Patentansprüche

1. Server (1000), umfassend:
ein Gehäuse (230) in der Gestalt einer Rahmenstruktur und umfassend einen ersten Aufnahmehohlraum (231), einen zweiten Aufnahmehohlraum (232), einen dritten Aufnahmehohlraum (233) und einen vierten Aufnahmehohlraum (234);
eine Vielzahl von Hash-Platinen (210), wobei die Vielzahl von Hash-Platinen (210) nebeneinander im ersten Aufnahmehohlraum (231) entlang einer Links-Rechts-Richtung angeordnet sind; wobei jede von der Vielzahl von Hash-Platinen (210) zur Links-Rechts-Richtung senkrecht ist, und jede Hash-Platine (210) im ersten Aufnahmehohlraum (231) verschiebbar angeordnet ist;
ein Leistungsmodul (220), das im zweiten Aufnahmehohlraum (232) angeordnet ist;
ein Steuerungsmodul (240), das im dritten Aufnahmehohlraum (233) verschiebbar angeordnet ist;
ein Leistungsversorgungsmodul (250), das im vierten Aufnahmehohlraum (234) verschiebbar angeordnet ist; wobei der vierte Aufnahmehohlraum (234) und der dritte Aufnahmehohlraum (233) in der Links-Rechts-Richtung verteilt sind und voneinander beabstandet sind;
eine elektrische Anschlussplatte (100), die im Gehäuse (230) angeordnet ist, worin die Vielzahl von Hash-Platinen (210), das Leistungsmodul (220), das Steuerungsmodul (240) und das Leistungsversorgungsmodul (250) alle mit der elektrischen Anschlussplatte (100) angeschlossen sind; das Leistungsmodul (220) ist dazu eingerichtet, die Vielzahl von Hash-Platinen (210) über die elektrische Anschlussplatte (100) mit Leistung zu versorgen, und das Leistungsversorgungsmodul (250) ist dazu eingerichtet, das Steuerungsmodul (240) über die elektrische Anschlussplatte (100) mit Leistung zu versorgen,
worin das Leistungsmodul (220) im zweiten Aufnahmehohlraum (232) des Gehäuses (230) verschiebbar angeordnet ist, und eine Erstreckungsrichtung des Leistungsmoduls (220) dieselbe ist wie diejenige der Vielzahl von Hash-Platinen (210);
worin die Vielzahl von Hash-Platinen (210), das Leistungsmodul (240) und das Leistungsversorgungsmodul (250) alle an einer Seite der elektrischen Anschlussplatte (100) entlang einer vorderen und hinteren Richtung angeordnet sind; und die vordere und hintere Richtung zur Erstreckungsrichtung der Vielzahl von Hash-Platinen (210) parallel ist,
worin eine Vielzahl von Leistungsmodulen (220) in der Links-Rechts-Richtung angeordnet sind, und jedes Leistungsmodul (220) dazu eingerichtet ist, zwei von vier Hash-Platinen (210) mit Leistung zu versorgen,
worin die elektrische Anschlussplatte (100) umfasst:
ein gedrucktes Leiterplattensubstrat (10), wobei das gedruckte Leiterplattensubstrat (10) zwei Kontaktbereiche (11) umfasst, die dazu eingerichtet sind, sich jeweils mit positiven und negativen Elektroden einer Leistungsversorgung zu verbinden, und zwei Seiten jedes Kontaktbereichs (11) jeweils mit einer ersten Kontaktfläche und einer zweiten Kontaktfläche (112) versehen sind, die dazu eingerichtet sind, einen Leiter zu kontaktieren, und jeder Kontaktbereich (11) eine Vielzahl von Durchgangslöchern (13) umfasst;
eine erste leitfähige Schicht (20), die an der ersten Kontaktfläche angeordnet ist, und eine zweite leitfähige Schicht (30), die an der zweiten Kontaktfläche (112) angeordnet ist;
eine dritte leitfähige Schicht (40), die in den Durchgangslöchern (13) angeordnet ist und mit der ersten leitfähigen Schicht (20) und der zweiten leitfähigen Schicht (30) elektrisch verbunden ist;
einen ersten leitfähigen Streifen (50), wobei der erste leitfähige Streifen (50) an der ersten leitfähigen Schicht (20) fixiert ist und mit der ersten leitfähigen Schicht (20) elektrisch verbunden ist, und der erste leitfähige Streifen (50) dazu eingerichtet ist, sich mit dem Leistungsmodul (220) zu verbinden; und
einen zweiten leitfähigen Streifen (60), wobei der zweite leitfähige Streifen (60) mit der zweiten leitfähigen Schicht (30) verbunden ist und mit der zweiten leitfähigen Schicht (30) elektrisch verbunden ist, und der zweite leitfähige Streifen (60) mit der Hash-Platine (210) des Servers (1000) elektrisch verbunden ist,
und worin der erste leitfähige Streifen (50) ein erstes leitfähiges Blatt (51), ein zweites leitfähiges Blatt (52) und ein Verbindungsblatt (53) umfasst, wobei das erste leitfähige Blatt (51) mit der ersten Leitungsschicht (20) verbunden ist, und das zweite leitfähige Blatt (52) mit dem Leistungsversorgungsmodul (220) verbunden ist, worin das Verbindungsblatt (53) zwischen dem ersten leitfähigen Blatt (51) und dem zweiten leitfähigen Blatt (52) angeordnet ist.

2. Server (1000) nach Anspruch 1, worin jede Hash-Platine (210) ein Buck-Schaltungsmodul umfasst; das Leistungsversorgungsmodul (250) dazu eingerichtet ist, eine erste WS-Spannung eines äußeren ersten WS in GS umzuwandeln und das Buck-Schaltungsmodul mit dem GS zu versorgen; und das Buck-Schaltungsmodul dazu eingerichtet ist, den GS zu reduzieren und einen Hash-Chip an der Hash-Platine (210) mit Leistung zu versorgen.

3. Server (1000) nach Anspruch 2, worin eine erste GS-Spannung des GS, die vom Leistungsmodul (220) umgewandelt wird, 48 V beträgt und eine zweite GS-Spannung des GS, der vom Buck-Schaltungsmodul der Hash-Platine (210) reduziert wird, 12 V beträgt.

4. Server (1000) nach Anspruch 2, worin das Leistungsversorgungsmodul (250) dazu eingerichtet ist, eine zweite WS-Spannung eines äußeren zweiten WS in eine dritte GS-Spannung von 12 V umzuwandeln und das Steuerungsmodul (240) mit Leistung zu versorgen.

5. Server (1000) nach Anspruch 4, worin ein Bereich der ersten WS-Spannung und der zweiten WS-Spannung 220-380 V ist.

6. Server (1000) nach Anspruch 1, worin das Steuerungsmodul (240) eine Steuerungsplatine (241) und eine erste Schaltplatte (246) umfasst, die an einem Ende der Steuerungsplatine (241) angeordnet ist; die erste Schaltplatte (246) eine erste Steuerungssignalschnittstelle (243) und eine zweite Steuerungssignalschnittstelle (245) umfasst; die erste Steuerungssignalschnittstelle (243) mit einem ersten Anschluss (116) der elektrischen Anschlussplatte (100) zur Signalverbindung verbunden ist; und die zweite Steuerungssignalschnittstelle (245) mit einem zweiten Anschluss (117) der elektrischen Anschlussplatte (100) zum Stromtransport verbunden ist; und
zwei Seiten des dritten Aufnahmehohlraums (233) mit Gleitstäben versehen sind, und zwei Seiten der Steuerungsplatine (241) mit Gleitnuten (242) versehen sind; die Steuerungsplatine (241) im dritten Aufnahmehohlraum (233) beweglich ist, wenn die Gleitstäbe in den Gleitnuten (242) gleiten.

7. Server (1000) nach Anspruch 6, worin das Leistungsversorgungsmodul (250) eine Leistungsversorgungsplatte (251) und eine zweite Schaltplatte (254) umfasst, die an einem Ende der Leistungsversorgungsplatte (251) angeordnet ist; die zweite Schaltplatte (254) eine erste Stromschnittstelle (252) und eine zweite Stromschnittstelle (253) umfasst; die erste Stromschnittstelle (252) dazu eingerichtet ist, sich mit einem dritten Anschluss (118) der elektrischen Anschlussplatte (100) zu verbinden, um zu einer äußeren Spannung Zugang zu haben, und die zweite Stromschnittstelle (253) dazu eingerichtet ist, sich mit einem vierten Anschluss (119) der elektrischen Anschlussplatte (100) zu verbinden, um den Strom zu übertragen.

8. Server (1000) nach Anspruch 1, worin die elektrische Anschlussplatte ferner zwei leitfähige Anschlussplatten (70) und eine Isolierschicht (80) umfasst; die zwei leitfähigen Anschlussplatten (70) jeweils mit zweiten leitfähigen Streifen (60) der zwei Kontaktbereiche (11) verbunden sind, um sich jeweils mit der positiven Elektrode und der negativen Elektrode der Leistungsversorgung zu verbinden; jede leitfähige Anschlussplatte (70) mit einer Vielzahl von leitfähigen Stiften (71) versehen ist, und die leitfähigen Stifte (71) an den zwei leitfähigen Anschlussplatten (70) eine nach der anderen zueinander passen, um eine Vielzahl von Paaren von leitfähigen Stiften (71) zu bilden; jedes Paar von leitfähigen Stiften (71) jeder Hash-Platine (210) entspricht und mit der Hash-Platine (210) zur Leistungsversorgung elektrisch verbunden ist; und
die Isolierschicht (80) zwischen den zwei leitfähigen Anschlussplatten (70) angeordnet ist, um einen Kurzschluss zwischen den leitfähigen Anschlussplatten (70) zu vermeiden, die die positive Elektrode und die negative Elektrode der Leistungsversorgung verbinden.

## Revendications

1. Serveur (1000), comprenant :
un boîtier (230) sous la forme d'une structure de cadre et comprenant une première cavité de logement (231), une seconde cavité de logement (232), une troisième cavité de logement (233) et une quatrième cavité de logement (234) ;
une pluralité de cartes de hachage (210), la pluralité de cartes de hachage (210) étant disposées côte à côte dans la première cavité de logement (231) le long d'une direction gauche-droite ; chacune de la pluralité de cartes de hachage (210) étant perpendiculaire à la direction gauche-droite, et chaque carte de hachage (210) étant disposée de manière coulissante dans la première cavité de logement (231) ;
un module de puissance (220) disposé dans la seconde cavité de logement (232) ;
un module de commande (240) disposé de manière coulissante dans la troisième cavité de logement (233) ;
un module d'alimentation (250) disposé de manière coulissante dans la quatrième cavité de logement (234) ; la quatrième cavité de logement (234) et la troisième cavité de logement (233) étant réparties dans la direction gauche-droite et espacées l'une de l'autre ;
une carte de connexion électrique (100) disposée dans le boîtier (230), dans lequel la pluralité de cartes de hachage (210), le module de puissance (220), le module de commande (240) et le module d'alimentation (250) sont tous connectés à la carte de connexion électrique (100) ; le module de puissance (220) est configuré pour alimenter en électricité la pluralité de cartes de hachage (210) via la carte de connexion électrique (100), et le module d'alimentation (250) est configuré pour alimenter en électricité le module de commande (240) via la carte de connexion électrique (100),
dans lequel le module de puissance (220) est disposé de manière coulissante dans la seconde cavité de logement (232) du boîtier (230), et une direction d'extension du module de puissance (220) est la même que celle de la pluralité de cartes de hachage (210) ;
dans lequel la pluralité de cartes de hachage (210), le module de commande (240) et le module d'alimentation (250) sont tous disposés sur un côté de la carte de connexion électrique (100) le long d'une direction avant et arrière ;
et la direction avant et arrière est parallèle à la direction d'extension de la pluralité de cartes de hachage (210),
dans lequel une pluralité de modules de puissance (220) sont disposés dans la direction gauche-droite, et chaque module de puissance (220) est configuré pour alimenter en électricité deux à quatre cartes de hachage (210),
dans lequel la carte de connexion électrique (100) comprend :
un substrat de PCB (10), le substrat de PCB (10) comprenant deux zones de contact (11) configurées pour se connecter à des électrodes positives et négatives d'une alimentation électrique, respectivement, et deux côtés de chaque zone de contact (11) étant respectivement pourvus d'une première surface de contact et d'une seconde surface de contact (112) configurées pour entrer en contact avec un conducteur, et chaque zone de contact (11) comprenant une pluralité de trous traversants (13) ;
une première couche conductrice (20) disposée sur la première surface de contact et une seconde couche conductrice (30) disposée sur la seconde surface de contact (112) ;
une troisième couche conductrice (40) disposée dans les trous traversants (13) et électriquement connectée à la première couche conductrice (20) et à la seconde couche conductrice (30) ;
une première bande conductrice (50), la première bande conductrice (50) étant fixée sur la première couche conductrice (20) et électriquement connectée à la première couche conductrice (20), et la première bande conductrice (50) étant configurée pour se connecter au module de puissance (220) ; et
une seconde bande conductrice (60), la seconde bande conductrice (60) étant connectée à la seconde couche conductrice (30) et électriquement connectée à la seconde couche conductrice (30), et la seconde bande conductrice (60) étant électriquement connectée à la carte de hachage (210) du serveur (1000),
et dans lequel la première bande conductrice (50) comprend une première feuille conductrice (51), une seconde feuille conductrice (52) et une feuille de connexion (53), la première feuille conductrice (51) étant connectée à la première couche conductrice (20), et la seconde feuille conductrice (52) étant connectée au module d'alimentation (220), dans lequel la feuille de connexion (53) est disposée entre la première feuille conductrice (51) et la seconde feuille conductrice (52).

2. Serveur (1000) selon la revendication 1, dans lequel chaque carte de hachage (210) comprend un module de circuit dévolteur ; le module d'alimentation (250) est configuré pour convertir une première tension CA d'un premier CA externe en CC et fournir le CC au module de circuit dévolteur ; et le module de circuit dévolteur est configuré pour réduire le CC et pour alimenter en électricité une puce de hachage sur la carte de hachage (210).

3. Serveur (1000) selon la revendication 2, dans lequel une première tension CC du CC convertie par le module de puissance (220) est de 48 V, et une seconde tension CC du CC réduite par le module de circuit dévolteur de la carte de hachage (210) est de 12 V.

4. Serveur (1000) selon la revendication 2, dans lequel le module d'alimentation (250) est configuré pour convertir une seconde tension CA d'un second CA externe en une troisième tension CC de 12 V et pour alimenter en électricité le module de commande (240).

5. Serveur (1000) selon la revendication 4, dans lequel une plage de la première tension CA et de la seconde tension CA est de 220 à 380 V.

6. Serveur (1000) selon la revendication 1, dans lequel le module de commande (240) comprend une carte de commande (241) et une première carte de circuit (246) disposée sur une extrémité de la carte de commande (241) ; la première carte de circuit (246) comprend une première interface de signal de commande (243) et une seconde interface de signal de commande (245) ; la première interface de signal de commande (243) est connectée à un premier port (116) de la carte de connexion électrique (100) pour la connexion de signal ; et la seconde interface de signal de commande (245) est connectée à un second port (117) de la carte de connexion électrique (100) pour le transport de courant ; et
deux côtés de la troisième cavité de logement (233) sont pourvus de barres coulissantes, et deux côtés de la carte de commande (241) sont pourvus de rainures coulissantes (242) ; la carte de commande (241) est mobile dans la troisième cavité de logement (233) lorsque les barres coulissantes coulissent dans les rainures coulissantes (242).

7. Serveur (1000) selon la revendication 6, dans lequel le module d'alimentation (250) comprend une carte d'alimentation (251) et une seconde carte de circuit (254) disposée sur une extrémité de la carte d'alimentation (251) ; la seconde carte de circuit (254) comprend une première interface de courant (252) et une seconde interface de courant (253) ; la première interface de courant (252) est configurée pour se connecter à un troisième port (118) de la carte de connexion électrique (100) pour accéder à une tension externe, et la seconde interface de courant (253) est configurée pour se connecter à un quatrième port (119) de la carte de connexion électrique (100) pour transmettre le courant.

8. Serveur (1000) selon la revendication 1, dans lequel la plaque de connexion électrique comprend en outre deux plaques de connexion conductrices (70) et une couche isolante (80) ; les deux plaques de connexion conductrices (70) sont respectivement connectées à des secondes bandes conductrices (60) des deux zones de contact (11) pour se connecter à l'électrode positive et à l'électrode négative de l'alimentation électrique respectivement ; chaque plaque de connexion conductrice (70) est pourvue d'une pluralité de broches conductrices (71), et les broches conductrices (71) sur les deux plaques de connexion conductrices (70) correspondent l'une à l'autre l'une après l'autre pour former une pluralité de paires de broches conductrices (71) ; chaque paire de broches conductrices (71) correspond à chaque carte de hachage (210) et est électriquement connectée à la carte de hachage (210) pour l'alimentation électrique ; et
la couche isolante (80) est disposée entre les deux plaques de connexion conductrices (70) pour éviter un court-circuit entre les plaques de connexion conductrices (70) se connectant à l'électrode positive et à l'électrode négative de l'alimentation électrique.
